# EUROPEAN PATENT APPLICATION

(11) **EP 2 015 628 A1**
(43) Date of publication of application: **14.01.2009**
(21) Application number: 08010355.9
(22) Date of filing: 06.06.2008
(51) Int. Cl.: H05K 9/00, H01F 1/26

(54) **Electromagnetic wave suppressing sheet**

(30) Priority: 12.07.2007 JP 2007182958
(71) Applicant: ALPS ELECTRIC CO., LTD., Tokyo 145-8501 (JP)
(72) Inventor: Mizushima, Takao, Tokyo 145-8501 (JP); Abiko, Seiichi, Tokyo 145-8501 (JP); Kawase, Kyoichi, Tokyo 145-8501 (JP); Takahashi, Toshio, Tokyo 145-8501 (JP); Maruyama, Satoshi, Tokyo 145-8501 (JP)
(74) Representative: Klunker . Schmitt-Nilson . Hirsch

(57) **Abstract**

An electromagnetic wave suppressing sheet (1) according to the invention is a sheet including a magnetic powder (2) and an insulating material (3). A real part (ε') of a permittivity (ε) in an in-plane direction of the sheet is 200 or more, and an imaginary part (ε") thereof is 25 or more. Accordingly, it is possible to obtain the electromagnetic wave absorbing sheet (1) which exhibits an excellent electric wave absorption characteristic in which an absorption amount of electromagnetic waves is large in the in-plane direction of the sheet.

## Description

### BACKGROUND

### 1. Field of the Invention

The present invention relates to an electromagnetic wave suppressing sheet having an excellent electric wave absorption characteristic.

### 2. Description of the Related Art

As a measure for noise, an electromagnetic wave suppressing sheet is embedded in cell phones or personal computers. The electromagnetic wave suppressing sheet has a characteristic absorbing electromagnetic waves and is formed with an internal structure in which a magnetic powder and an insulating material are mixed.

An electric wave absorber is described in JP-A-2005-209686, JP-A-2005-159337, JP-A-2005-116819, JP-A-2005-307291, Japanese Patent No. 3710226, and Japanese Patent No. 3771224.

It is preferable to increase a conductivity, a permittivity, and a permeability of an electric wave absorber sheet to thereby improve the electric wave absorption characteristic (noise absorption effect).

For example, in JP-A-2005-209686, there is described that the electric wave absorption characteristic is improved by increasing the permittivity. For example, in JP-A-2005-209686, a Fe-Al-Si alloy is used as a magnetic powder. However, when the Fe-Al-Si alloy is used, the electric wave absorption characteristic can not be improved by increasing the permittivity while maintaining a sheet thickness thin.

In JP-A-2005-159337, JP-A-2005-116819, JP-A-2005-307291, Japanese Patent No. 3710226, and Japanese Patent No. 3771224, there is also not described that the electric wave absorption characteristic is improved by increasing the permittivity while maintaining a sheet thickness thin.

### SUMMARY

On that account, the invention is contrived to solve the above conventional problem, and particularly, an object of the invention is to provide an electromagnetic wave suppressing sheet in which an electric wave absorption characteristic can be improved by increasing a permittivity while maintaining a sheet thickness thin.

An electromagnetic wave suppressing sheet according to the invention includes a magnetic powder and an insulating material, and real part (ε') of a permittivity (ε) in an in-plane direction of the sheet is 200 or more, and an imaginary part (ε") thereof is 25 or more.

Thanks to this, it is possible to obtain an electromagnetic wave absorbing sheet which exhibits an excellent electric wave absorption characteristic in which an absorption amount of electromagnetic waves is large in an in-plane direction of the sheet.

Otherwise, an electromagnetic wave suppressing sheet according to the invention includes a magnetic powder and a insulating material, and a real part (ε') and an imaginary part (ε") of a permittivity (ε) have an anisotropy in an in-plane direction of the sheet.

Here, 'anisotropy' means that the real part (ε') and the imaginary part (ε") of the permittivity (ε) in the in-plane direction of the sheet are larger than the real part (ε') and the imaginary part (ε") of the permittivity (ε) in the thickness direction of the sheet. Further, it also means that the real part (ε') of the permittivity (ε) in the in-plane direction of the sheet/the real part (ε') of the permittivity (ε) in the thickness direction of the sheet, and the imaginary part (ε") of the permittivity (ε) in the in-plane direction of the sheet/the imaginary part (ε") of the permittivity (ε) in the thickness direction of the sheet are 10 or more, preferably 20 or more, and more preferably 100 or more.

Thanks to this, it is possible to obtain an electromagnetic wave absorbing sheet which exhibits an excellent electric wave absorption characteristic in which an absorption amount of electromagnetic waves is large in an in-plane direction of the sheet.

According to the invention, it is preferable that the filling density of the magnetic powder is in the range of 2.3 g/cm³ to 3.5 g/cm³. By realizing high-density, it is possible to increase the real part (ε') and the imaginary part (ε") of the permittivity (ε) in the in-plane direction of the sheet, respectively.

According to the invention, it is preferable that the content of the magnetic powder is in the range of 30 vol% or more and less than 45 vol%. Further, it is preferable that the content of the magnetic powder is in the range of 30 vol% to 40 vol%. Thanks to this, a distance between the layers of magnetic powder can be effectively reduced and the insulating material can be properly disposed between the layers of magnetic powder to thereby suppress the formation of bubbles. In addition, it is possible to increase the real part (ε') and the imaginary part (ε") of the permittivity (ε) in the in-plane direction of the sheet, respectively, while maintaining a sheet thickness thin.

According to the invention, it is preferable that an average particle size (D50) of the magnetic powder is in the range of 24 µm to 70 µm. Resistivity of the magnetic powder can be increased when the particle size is large, and it is possible to increase the real part (ε') and the imaginary part (ε") of the permittivity (ε) in the in-plane direction of the sheet, respectively.

Further, according to the invention, it is preferable that an aspect ratio of the magnetic powder is in the range of 10 to 800. Thanks to this, the magnetic powder can be properly dispersed over the whole inner part of the sheet, and a distance between the layers of magnetic powder can be effectively reduced. In addition, an insulation property between the layers of magnetic powder can be maintained, and an excellent electric wave absorption characteristic can be obtained.

In addition, according to the invention, it is preferable that the magnetic powder is a Fe-based amorphous alloy containing a low annealing promotion element M of 5 at% or less and Ni of 10 at% or less, where M is at least one selected from a group consisting of Sn, In, Zn, Ga, Co, and Al, and a flat magnetic metal alloy represented by a composition formula Fe_{100-a-b-x-y-z-w-t}MₐNi_{b}CrₓP_{y}C_{z}B_{w}Siₜ (where 0 at%≤a≤5 at%, 0 at%≤b≤10 at%, 0 at%≤x≤ 4 at%, 6 at%≤y≤13 at%, 2 at%≤z≤12 at%, 0 at%≤w≤5 at%, and 0 at%≤t≤ 4 at%), the magnetic powder is dispersed in layers in a film thickness direction with the insulating material disposed therebetween, the insulating material is formed of chlorinated polyethylene having a chlorination degree of 30 mass% to 40 mass%, and a sheet thickness is in the range of 20 µm to 200 µm. It is more preferable that the sheet thickness is 100 µm or less.

As described above, according to the invention, it is possible to exhibit an excellent electric wave absorption characteristic while maintaining a sheet thickness thin.

### BRIEF DESCRIPTION OF THE DRAWINGS

Fig. 1 is a perspective view of an electromagnetic wave suppressing sheet according to an embodiment of the invention;
Fig. 2 is a schematic view (partially enlarged view) of a cross section cut in a film thickness direction of the electromagnetic wave suppressing sheet according to the embodiment of the invention;
Fig. 3 is a graph showing a relationship between a chlorination degree of chlorinated polyethylene and the filling density of a magnetic powder;
Fig. 4 is a graph showing a relationship between the content of the magnetic powder and the filling density of the magnetic powder;
Fig. 5 is a graph showing a relationship between the content of the magnetic powder and a real part µ' of a complex relative permeability (13.56 MHz);
Fig. 6 is a graph showing a relationship between the content of the magnetic powder and an imaginary part µ" of the complex relative permeability (1 GHz);
Fig. 7 is a graph showing a relationship between the content of the magnetic powder and a relative density;
Fig. 8 is a graph showing a relationship between the content of the magnetic powder and a real part ε' and an imaginary part ε" of a complex relative permittivity in an in-plane direction of the sheet;
Fig. 9A is a scanning electron micrograph (SEM photograph) of a cross section cut in a film thickness direction of an electromagnetic wave suppressing sheet of an example (magnetic powder: Fe_{67.9}Co₄Ni₄Sn_{3.5}P_{8.8}C_{10.8}B₁);
Fig. 9B is a scanning electron micrograph (SEM photograph) of a cross section cut in a film thickness direction of an electromagnetic wave suppressing sheet of a comparative example (magnetic powder: Fe-Si-Al alloy);
Fig. 10 is a graph showing a measurement result of a real part ε' of a complex relative permittivity and an imaginary part ε" of the complex relative permittivity in a frequency band of 500 MHz to 9 GHz, which uses a first electromagnetic wave suppressing sheet (chlorinated polyethylene: manufactured by Showa Denko Kabushiki Kaisha (chlorination degree: 40%), sheet thickness: 91 µm) of an example;
Fig. 11 is a graph showing a measurement result of a real part ε' of a complex relative permittivity and an imaginary part ε" of the complex relative permittivity in a frequency band of 500 MHz to 9 GHz, which uses a second electromagnetic wave suppressing sheet (chlorinated polyethylene: manufactured by Showa Denko Kabushiki Kaisha (chlorination degree: 35%), sheet thickness: 86 µm) of an example;
Fig. 12 is a graph showing a measurement result of a real part ε' of a complex relative permittivity and an imaginary part ε" of the complex relative permittivity in a frequency band of 500 MHz to 9 GHz, which uses a third electromagnetic wave suppressing sheet (chlorinated polyethylene: manufactured by Showa Denko Kabushiki Kaisha (chlorination degree: 40%), sheet thickness: 65 µm) of an example;
Fig. 13 is a graph showing a measurement result of a real part ε' of a complex relative permittivity and an imaginary part ε" of the complex relative permittivity in a frequency band of 500 MHz to 9 GHz, which uses a fourth electromagnetic wave suppressing sheet (chlorinated polyethylene: manufactured by Showa Denko Kabushiki Kaisha (chlorination degree: 35%), sheet thickness: 59 µm) of an example;
Fig. 14 is a graph showing a frequency characteristic of a real part ε' of a complex relative permittivity and an imaginary part ε" of the complex relative permittivity in a thickness direction of an electromagnetic wave suppressing sheet of an example; and
Fig. 15 is a graph showing a frequency characteristic of a real part ε' of a complex relative permittivity and an imaginary part ε" of the complex relative permittivity in an in-plane direction of an electromagnetic wave suppressing sheet of an example.

### DESCRIPTION OF THE PREFERRED EMBODIMENTS

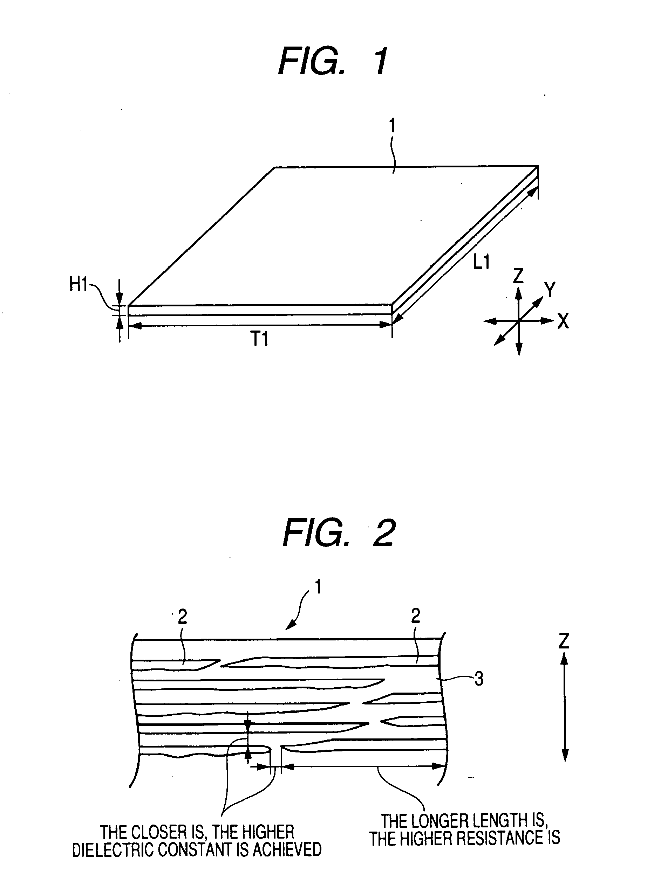

Fig. 1 is a perspective view of an electromagnetic wave suppressing sheet according to this embodiment of the invention. A size of the electromagnetic wave suppressing sheet 1 is changed depending on an intended use or a range of use. However, for example, a transverse dimension T1 (dimension in a X direction shown in the figure) is 10 mm or more, and a longitudinal dimension L1 (dimension in a Y direction shown in the figure) is 10 mm or more. Further, a sheet thickness H1 (dimension in a z direction shown in the figure) of the electromagnetic wave suppressing sheet 1 is in the range of 20 µm to 200 µm. According to this embodiment of the invention, it is possible to exhibit an excellent electric wave absorption characteristic (noise suppressing effect), even when the sheet thickness H1 is thinner than 200 µm or less or 100 µm or less. The sheet thickness H1 is preferably 50 µm or more, and more preferably 80 µm or more.

As shown in Fig. 2, the electromagnetic wave suppressing sheet 1 is produced by mixing a magnetic powder 2 and an insulating material 3. Fig. 2 is a partially enlarged schematic view of a cross section cut in a film thickness direction (in a z direction shown in the figure) of the electromagnetic wave suppressing sheet 1.

The magnetic powder 2 is a flat amorphous magnetic alloy represented by a composition formula Fe_{100-a-b-x-y-z-w-t}MₐNi_{b}CrₓP_{y}C_{z}B_{w}Siₜ (where 0 at%≤a≤5 at%, 0 at%≤b≤10 at%, 0 at%≤x≤ 4 at%, 6 at%≤y≤13 at%, 2 at%≤z≤12 at%, 0 at%≤w≤5 at%, and 0 at%≤t≤ 4 at%). Here, any one or both of a low annealing promotion element M (at least one element selected from a group consisting of Sn, In, Zn, Ga, Co, and Al) of 5 at% or less and Ni of 10 at% or less may be included.

The magnetic powder 2 according to this embodiment of the invention includes Fe indicating magnetism, and metalloid elements such as P, C, and B having an amorphous formability. Accordingly, the magnetic powder 2 has an amorphous phase as a main phase and exhibits an excellent soft magnetic characteristic.

Further, the magnetic powder 2 has a supercooled-liquid temperature interval ΔTx of 20 K or more, represented by an equation ΔTx=Tx-Tg (where Tx is a crystallization initiating temperature and Tg is a glass transition temperature). However, depending on the composition, the magnetic powder 2 has a significant temperature interval ΔTx of 30 K or more, or further 50 K or more, and has excellent soft magnetism at a room temperature.

An amount of Fe of the magnetic powder 2 (Fe_{100-a-b-x-y-z-w-t}MₐNi_{b}CrₓP_{y}C_{z}B_{w}Siₜ) according to this embodiment of the invention is preferably in the range of 70 at% to 80 at%, more preferably in the range of 72 at% to 79 at%, and even more preferably in the range of 73 at% to 78 at%. When the amount of Fe is large as described above, high saturation magnetization is exhibited. In addition, when the additive amount of Fe is more than 80 at%, a reduced glass transition temperature (Tg/Tm) indicating a degree of the amorphous formability of the alloy is less than 0.54. It is not preferable since the amorphous formability is deteriorated. In the above equation, Tm is a melting point of the magnetic powder 2.

Particularly, when an amount of Sn as the low annealing promotion element M is 3.5 at% and an amount of Ni is 4 at% or more in the Fe-based amorphous alloy, the crystallization temperature Tx is as low as about 662 K. Further, when an amount of Sn as the low annealing promotion element M is 3.5 at% and an additive amount of Ni is 4 at% or more in the Fe-based amorphous alloy, the melting point Tm is as low as 1256 K or less. In the ranges of the amounts of additives, it is most desirable that the additive amount of the low annealing promotion element is 3.5 at% and the additive amount of Ni is 4 at% or more when considering the formation of the amorphous state.

It is preferable that the Fe-based amorphous alloy according to the invention has the composition formula Fe_{100-a-b-x-y-z-w-t}MₐNi_{b}CrₓP_{y}C_{z}B_{w}Siₜ.

As described above, when the low annealing promotion element M is included with Ni, the crystallization temperature Tx and the melting point Tm are lowered. When considering the formation of the amorphous state, the content of the low annealing promotion element M is preferably set to be 0 at%≤a≤5 at% in the above composition formula.

Ni lowers the glass transition temperature Tg, the crystallization temperature Tx, and the melting point Tm by substitution with Fe. When considering the saturation magnetization or the melting point Tm, the content of Ni is preferably set to be 0 at%≤b≤ 10 at%, and more preferably set to be 4 at% ≤b≤ 6 at% in the composition formula.

When considering corrosion resistance, thermal stability, and the saturation magnetization of the alloy, the content of Cr is preferably set to be 0 at%≤x≤4 at%, and more preferably set to be 2 at%≤x≤4 at% in the composition formula.

When considering that it is preferable to employ a composition similar to the eutectic composition of the ternary alloy of Fe-P-C (Fe_{79.4}P_{10.8}C_{9.8}), the content of P is preferably set to be 6 at%≤y≤13 at%, and more preferably set to be 6 at%≤y≤11 at% in the above composition formula.

When considering that it is preferable to employ a composition similar to the eutectic composition of the ternary alloy of Fe-P-C (Fe_{79.4}P_{10.8}C_{9.8}), the content of C is preferably set to be 2 at%≤z≤12 at%, and more preferably set to be 6 at%≤z≤11 at% in the above composition formula.

When considering the rise of the glass transition temperature Tg, the crystallization temperature Tx, and the melting point Tm, the content of B is preferably set to be 0 at%≤w≤ 5 at%, more preferably set to be 0 at%≤w≤2 at%, and even more preferably set to be 1 at%≤w≤2 at% in the above composition formula.

When considering the rise of the glass transition temperature Tg, the crystallization temperature Tx, and the melting point Tm, the content of Si is preferably set to be 0 at%≤t≤4 at%, more preferably set to be 0 at%≤t≤2 at%, and even more particularly set to be 1 at%≤t≤2 at%.

According to this embodiment of the invention, with any composition of the above cases, the supercooled-liquid temperature interval ΔTx of 20 K or more is obtained. Depending on the composition, the supercooled-liquid temperature interval ΔTx of 35 K or more is obtained.

Unavoidable impurities may be included as well as the elements shown in the above composition.

As shown in Fig. 2, the magnetic powder 2 is formed to be flat, and the layers of magnetic powder 2 are dispersed in a layer shape in the film thickness direction (in the z direction shown in the figure) with the insulating material 3 disposed between the layers of magnetic powder 2.

According to this embodiment of the invention, the insulating material 3 is formed of chlorinated polyethylene having a chlorination degree of 30 mass% to 40 mass%. As the chlorinated polyethylene, 'ELASLEN', manufactured by Showa Denko Kabushiki Kaisha, can be used. In the insulating material 3, a small amount of additives such as a lubricant agent, a silane coupling agent, and the like may be added.

Using the chlorinated polyethylene having a chlorination degree of 30 mass% to 40 mass% as the insulating material 3, a loading property (filling property) of the magnetic powder 2 with respect to the insulating material 3 can be increased, and a distance between the layers of magnetic powder 2 can be properly reduced. Further, the magnetic powder 2 composed of the above composition according to this embodiment of the invention has sufficiently higher resistivity than, for example, a Fe-Al-Si alloy (specifically, more than two times). In addition, the flat magnetic powder 2 composed of the above composition according to this embodiment of the invention is dispersed in a layer shape in the film thickness direction (in the z direction shown in the figure) with the insulating material 3 disposed between the layers of magnetic powder 2, and an interaction between the magnetic powder 2 and the chlorinated polyethylene is strong. The magnetic powder 2 and the insulating material 3 of chlorinated polyethylene are properly close to each other, and little bubbles are formed between the magnetic powder 2 and the insulating material 3. As described above, even when the sheet thickness is as thin as 200 µm or less, and further particularly 100 µm or less, both of a real part ε' of a complex relative permittivity and an imaginary part ε" of the complex relative permittivity in an in-plane direction of the sheet can be increased, and an excellent electric wave absorption characteristic can be obtained while maintaining a sheet thickness thin.

Specifically, in a frequency band of several hundreds MHz to several tens GHz, the real part ε' of the complex relative permittivity of about 200 to 900 in the in-plane direction of the sheet and the imaginary part ε" of the complex relative permittivity of about 25 to 900 in the in-plane direction of the sheet can be obtained while maintaining a sheet thickness of 200 µm or less, and further particularly 100 µm or less. It is preferable that the imaginary part ε" of the complex relative permittivity is 30 or more. Such a high relative permittivity of the electromagnetic wave suppressing sheet 1 according to the invention largely affects a surface activation state of the chlorinated polyethylene and the amorphous magnetic alloy (magnetic powder). However, for example, as shown in tests to be described later, the relative permittivity as above can not be obtained when a Fe-Al-Si alloy or a NiFe alloy is used as the magnetic powder 2. It is considered that this is because of a difference of the interaction between the surface of the magnetic powder and the chlorinated polyethylene.

Further, the electromagnetic wave suppressing sheet according to the invention has a characteristic in which a real part (ε') and an imaginary part (ε") of a permittivity (ε) have an anisotropy in the in-plane direction of the sheet.

Here, 'anisotropy' means that the real part (ε') and the imaginary part (ε") of the permittivity (ε) in the in-plane direction of the sheet are larger than the real part (ε') and the imaginary part (ε") of the permittivity (ε) in the thickness direction of the sheet. Further, it also means that the real part (ε') of the permittivity (ε) in the in-plane direction of the sheet/the real part (ε') of the permittivity (ε) in the thickness direction of the sheet, and the imaginary part (ε") of the permittivity (ε) in the in-plane direction of the sheet/the imaginary part (ε") of the permittivity (ε) in the thickness direction of the sheet are 10 or more, preferably 20 or more, and more preferably 100 or more.

A mixed state of a metal and a resin can be shown as a small condenser assembly. Accordingly, by employing the above dense structure, condenser capacities increases, and a high permittivity is obtained. In the case of amorphous magnetic alloy (magnetic powder) according to the invention, surface activity is high since the magnetic powder has an amorphous structure, and adhesion to the chlorinated polyethylene is higher than other crystalline resins. Accordingly, a fine structure in the sheet becomes dense and a higher filling state is realized than a crystalline metal sheet. In addition, when viewed in the in-plane direction, a distance between the metals is shorter and the longer a length in a longitudinal direction of the metal is, the higher resistance is, thereby easily realizing a high permittivity. Accordingly, the electromagnetic wave suppressing sheet 1 having the amorphous magnetic alloy (magnetic powder) according to the invention realizes a high permittivity in the in-plane direction.

The electromagnetic wave suppressing sheet 1 can be formed in an ultrathin film. Accordingly, the electromagnetic wave suppressing sheet 1 does not obstruct the installation of a component, when being attached to an internal wall surface of a casing of a small device such as a cell phone. Further, the flat surface of the electromagnetic wave suppressing sheet 1 shown in Fig. 1 is not limited to a rectangular shape, can be processed in various shapes, and has excellent bendability. Accordingly, a freedom degree related to the installation of the electromagnetic wave suppressing sheet 1 is very high, and it is possible to make assurance doubly sure on a measure for noise by using the electromagnetic wave suppressing sheet 1 according to the invention in any electronic device.

In this embodiment of the invention, it is preferable that the filling density of the magnetic powder 2 is in the range of 2.3 g/cm³ to 3.5 g/cm³. As shown in the tests to be described later, the filling density of the magnetic powder 2 has a close relationship to the chlorination degree of the chlorinated polyethylene. However, it is difficult to obtain the above filling density when, for example, a Fe-Al-Si alloy or a NiFe alloy is used as the magnetic powder 2. Using the amorphous magnetic alloy as the magnetic powder 2, which has the above composition and a strong interaction with the chlorinated polyethylene, the relative permittivities ε' and ε", which are high in the in-plane direction of the sheet as described above, can be obtained in a state in which the filling density is high.

In addition, it is preferable that the content of the magnetic powder 2 is in the range of 30 vol% or more and less than 45 vol%. Accordingly, the distance between the layers of magnetic powder 2 can be effectively reduced, the insulating material 3 can be properly disposed between the layers of magnetic powder 2, and the formation of bubbles can be properly suppressed. As described above, the sheet thickness H1 can be properly reduced to 200 µm or less or 100 µm or less, and while maintaining such a sheet thickness, the real part ε' of the complex relative permittivity and the imaginary part ε" of the complex relative permittivity in the in-plane direction of the sheet can be effectively increased. Moreover, a permeability (real part µ' and imaginary part µ" of complex relative permeability) can be also properly increased. In this embodiment of the invention, it is more preferable that the content of the magnetic powder 2 is in the range of 35 vol% to 40 vol%.

It is preferable that an average particle size (D50) of the magnetic powder 2 is in the range of 24 µm to 70 µm. Here, D50 is a 50% accumulation particle size (median particle size). Since the magnetic powder 2 according to this embodiment of the invention is flat, the average particle size is obtained by the average value of the long side and the short side. It is more preferable that the average particle size (D50) is 50 µm or less.

As shown in the tests to be described later, when the average particle size is large, resistivity of the magnetic powder 2 can be increased and the real part ε' of the complex relative permittivity and the imaginary part ε" of the complex relative permittivity can be effectively increased. However, when the average particle size is too large, the amount of insulating material 3 is reduced relatively, and the layers of magnetic powder 2 easily come into contact with each other. Further, since the amount of insulating material 3 disposed between the layers of magnetic powder 2 is reduced and bubbles are thereby easily formed, the real part ε' of the complex relative permittivity and the imaginary part ε" of the complex relative permittivity are easily reduced. Accordingly, in this embodiment of the invention, the average particle size (D50) of the magnetic powder 2 is specified in the range of 24 µm to 70 µm.

Further, it is preferable that an aspect ratio (horizontal to vertical ratio) of the magnetic powder 2 is in the range of 10 to 800. Accordingly, the contact between the layers of magnetic powder 2 can be suppressed, and the magnetic powder 2 can be uniformly dispersed. In addition, the filling density of the magnetic powder 2 can be increased, and the real part ε' of the complex relative permittivity and the imaginary part ε" of the complex relative permittivity in the in-plane direction of the sheet can be effectively increased. The upper limit of the aspect ratio is more preferably 300, and most preferably 100.

The magnetic powder 2 according to the invention is produced by, for example, producing a substantially spherical amorphous magnetic powder by means of a water atomization method and processing the amorphous magnetic powder to be flat by an attritor or the like.

A solution is prepared by mixing chlorinated polyethylene having a chlorination degree of 30 mass% to 40 mass% in a solvent such as toluene, methyl ethyl ketone (MEK), or the like.

Next, a slurry is obtained by adding the magnetic powder 2 in the solution and stirring it. The slurry is applied by, for example, a doctorblade method, and then heated. As a result, the electromagnetic wave suppressing sheet 1 having a sheet shape is formed.

### Examples

### [Test Example 1: Chlorination Degree]

The following electromagnetic wave suppressing sheets were manufactured.

In an example, chlorinated polyethylene (ELASLEN, manufactured by Showa Denko Kabushiki Kaisha) having a chlorination degree of 30 mass% or 40 mass% was used, and the content of a magnetic powder was 35 vol% or 40 vol%.

In a comparative example, chlorinated polyethylene (ELASLEN, manufactured by Showa Denko Kabushiki Kaisha) having a chlorination degree of 45 mass% was used, and the content of a magnetic powder was 35 vol% or 40 vol%.

In the example and comparative example, as the magnetic powder, an amorphous magnetic alloy composed of Fe_{67.9}Co₄Ni₄Sn_{3.5}P_{8.8}C_{10.8}B₁ (at%) was used. The magnetic powder was flat. In addition, an average particle size (D50) of the magnetic powder was 58 µm, and an aspect ratio thereof was 102.

A sheet thickness of each electromagnetic wave suppressing sheet of the example was 90 µm, and a sheet thickness of each electromagnetic wave suppressing sheet of the comparative Example was 92 µm.

In a test, a real part ε' of a complex relative permittivity and an imaginary part ε" of the complex relative permittivity in an in-plane direction of each sheet were obtained at a frequency of 500 MHz or 1 GHz, respectively. The test result is shown in the following Table 1.

**[Table 1]**

| | Chlorination Degree wt% | Content of Magnetic Powder (vol%) | | 500 MHz | 1 GHz |
|---|---|---|---|---|---|
| Comparative Example | 45 | 40 | ε' | 105 | 98 |
| | | | ε" | 10 | 8 |
| | | 35 | ε' | 120 | 118 |
| | | | ε" | 18 | 12 |
| Example | 40 | 40 | ε' | 218 | 205 |
| | | | ε" | 34 | 29 |
| | | 35 | ε' | 228 | 216 |
| | | | ε" | 39 | 31 |
| | 30 | 40 | ε' | 673 | 616 |
| | | | ε" | 210 | 175 |
| | | 35 | ε' | 535 | 497 |
| | | | ε" | 139 | 119 |

As a comparative test with respect to this test, electromagnetic wave suppressing sheets were manufactured by using a Fe-Al-Si alloy (flat powder PST-4-FM60, manufactured by Sanyo Special Steel Co., Ltd., D50 of about 50 µm, aspect ratio of 100) and chlorinated polyethylene having a chlorination degree of 30 mass%, 35 mass%, 40 mass%. In the test, relative permittivities ε' and ε" in an in-plane direction of the sheets were obtained as the test of Table 1. The test result is shown in the following Table 2.

**[Table 2]**

| Permittivity of Fe-Al-Si Sheet | | | | |
|---|---|---|---|---|
| Chlorination Degree % | Powder Filling Factor (vol%) | | 500 MHz | 1 GHz |
| 40 | 35 | ε' | 188 | 185 |
| | | ε" | 11 | 10 |
| | 40 | ε' | 242 | 238 |
| | | ε" | 15 | 16 |
| 35 | 35 | ε' | 179 | 173 |
| | | ε" | 13 | 11 |
| | 40 | ε' | 298 | 297 |
| | | ε" | 23 | 22 |
| 30 | 35 | ε' | 169 | 164 |
| | | ε" | 13 | 12 |
| | 40 | ε' | 273 | 270 |
| | | ε" | 22 | 20 |

As shown in Table 1, all of the real parts ε' of the complex relative permittivities and the imaginary parts ε" of the complex relative permittivities of the example were more higher than those of the comparative example. It was known that, in the example, in a frequency band of 500 MHz to 1 GHz, the real part ε' of the complex relative permittivity can be about 200 or more, and preferably about 500 or more, and the imaginary part ε" of the complex relative permittivity can be about 25 or more, preferably about 30 or more, and more preferably about 100 or more. As shown in Table 2, in the case of Fe-Al-Si alloy, large real part ε' of the complex relative permittivity and imaginary part ε" of the complex relative permittivity can not be obtained even when the chlorinated polyethylene is used. Further, clear dependency on the chlorination degree can not be viewed.

From the test results, the chlorination degree of chlorinated polyethylene was specified in the range of 30 mass% to 40 mass%.

### [Test Example 2: Filling density of Magnetic Powder]

In a test, electromagnetic wave suppressing sheets using chlorinated polyethylene (ELASLEN, manufactured by Showa Denko Kabushiki Kaisha) having a chlorination degree of 30 mass%, 40 mass%, or 45 mass% were formed, and a relationship between a chlorination degree and a filling density was examined.

A magnetic powder used in the test was an amorphous magnetic alloy composed of Fe_{67.9}CO₄Ni₄Sn_{3.5}P_{8.8}C_{10.8}B₁, and the magnetic powder was flat. In addition, an average particle size (D50) of the magnetic powder was 56 µm, and an aspect ratio thereof was 100.

Sheet thicknesses of the electromagnetic suppressing sheets were 90 µm.

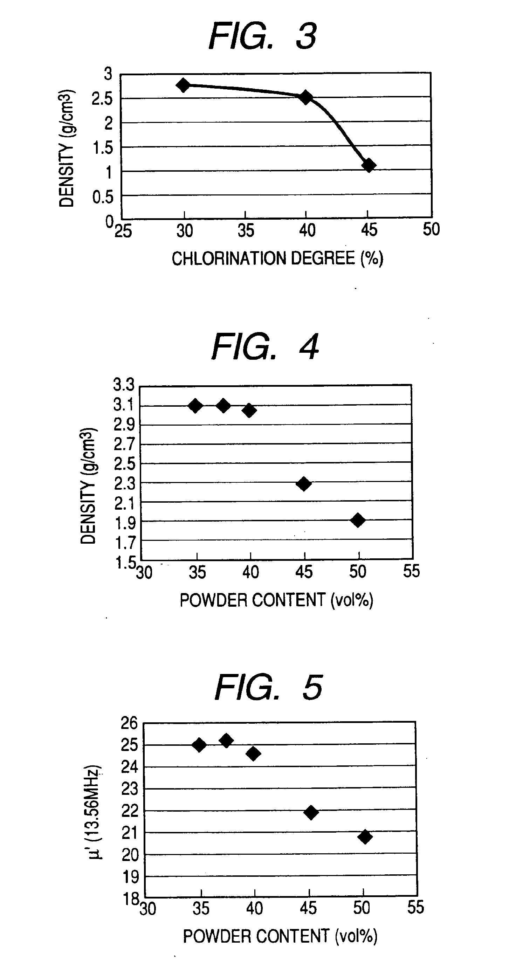

The relationship between the chlorination degree and the filling density of the magnetic powder is shown in the following Table 3 and Fig. 3.

**[Table 3]**

| Chlorination Degree (%) | Density (g/cm³) |
|---|---|
| 30 | 2.837 |
| 40 | 2.494 |
| 45 | 1.118 |

As shown in Table 3 and Fig. 3, it was known that the filling density of the magnetic powder is reduced when the chlorination degree is more than 40 mass%. When the chlorination degree increases, a bonding force of the chlorinated polyethylene with each other becomes strong and the magnetic powder has a difficulty in entering the network structure of the chlorinated polyethylene. Accordingly, it is considered that the filling density is reduced.

### [Test Example 3: Content of Magnetic Powder]

The following electromagnetic wave suppressing sheets were manufactured.

The content of a magnetic powder was set to 35 vol%, 37.5 vol%, 40 vol%, 45 vol%, or 50 vol%.

As a magnetic powder, an amorphous magnetic alloy composed of Fe_{67.9}Co₄Ni₄Sn_{3.5}P_{8.8}C_{10.8}B₁ was used, and the magnetic powder was flat. In addition, an average particle size (D50) of the magnetic powder was 56 µm, and an aspect ratio thereof was 100.

Chlorinated polyethylene (ELASLEN, manufactured by Showa Denko Kabushiki Kaisha) having a chlorination degree of 30 mass% was used.

In a test, a sheet thickness, a real part µ' of a complex relative permeability (13.56 MHz), and an imaginary part µ" of the complex relative permeability (1 GHz) in an in-plane direction of each electromagnetic wave suppressing sheet, a filling density of a magnetic powder, and a relative density were obtained, respectively. The test result is shown in the following Table 4.

**[Table 4]**

| Samp. | Content (vol%) | Thickness (µm) | µ' 13.56 M | µ" 1 G | Density (g/cm³) | Relative Density (%) |
|---|---|---|---|---|---|---|
| 1 | 35 | 86.00 | 24.97 | 6.35 | 3.122 | 96.3 |
| 2 | 37.5 | 81.67 | 25.21 | 6.32 | 3.122 | 92.0 |
| 3 | 40 | 90.67 | 24.71 | 6.30 | 3.055 | 86.2 |
| 4 | 45 | 137.00 | 21.83 | 5.61 | 2.272 | 59.0 |
| 5 | 50 | 185.33 | 20.76 | 5.54 | 1.897 | 45.7 |

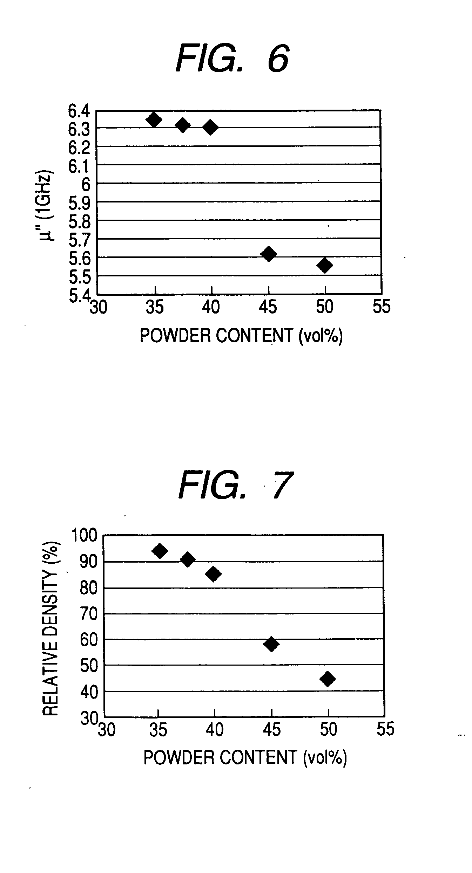

Fig. 4 shows a relationship between the content of the magnetic powder and the filling density of the magnetic powder, Fig. 5 shows a relationship between the content of the magnetic powder and the real part µ' of the complex relative permeability (13.56 MHz), Fig. 6 shows a relationship between the content of the magnetic powder and the imaginary part µ" of the complex relative permeability (1 GHz), and Fig. 7 shows a relationship between the content of the magnetic powder and the relative density.

It was known that it is preferable that the content of the magnetic powder is in the range of 35 vol% to 40 vol%.

As shown in Fig. 4, it was known that the filling density of the magnetic powder greatly increases when, for example, the content of the magnetic powder is 40 vol% or less.

From the test results shown in Tables 3 and 4 and Fig. 4, the filling density of the magnetic powder was specified in the range of 2.3 g/cm³ to 3.5 g/cm³.

As shown in Figs. 5 to 7, it was known that all of the real part µ' of the complex relative permeability (13.56 MHz), the imaginary part µ" of the complex relative permeability (1 GHz) and the relative density greatly increase when the content of the magnetic powder is 40 vol% or less.

Next, using electromagnetic wave suppressing sheets having different contents of a magnetic powder, a real part ε' of a complex relative permittivity, an imaginary part ε" of the complex relative permittivity, a real part µ' of the complex relative permeability and an imaginary part µ" of the complex relative permeability in an in-plane direction of the sheet were obtained, respectively, at a frequency of 900 MHz. The test result is shown in the following Table 5.

**[Table 5]**

| Filling Factor | ε' | ε" | µ' | µ" |
|---|---|---|---|---|
| 35% | 559.53 | 84.24 | 10.48 | 6.50 |
| 37.50% | 655.91 | 115.86 | 9.28 | 4.82 |
| 40% | 938.78 | 223.56 | 10.44 | 6.12 |
| 45% | 490.64 | 72.57 | 8.26 | 5.39 |
| 50% | 297.60 | 30.73 | 8.23 | 5.75 |

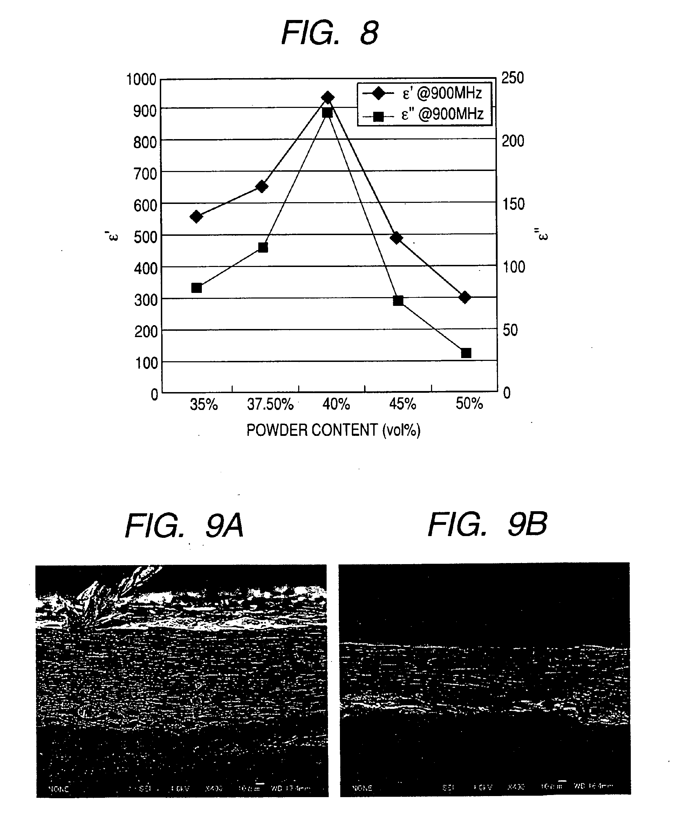

Fig. 8 is a graph showing a relationship between the content of the magnetic powder and the real part ε' and the imaginary part ε" of the complex relative permittivity in the in-plane direction of the sheet, which were obtained from the above test result.

As shown in Fig. 8, it was known that the real part ε' of the complex relative permittivity and the imaginary part ε" of the complex relative permittivity gradually increase as the content of the magnetic powder increases up to 40 vol%, and the real part ε' of the complex relative permittivity and the imaginary part ε" of the complex relative permittivity are gradually reduced when the content of the magnetic powder increases more than 40 vol%.

### [Test Example 4: Average Particle Size of Magnetic Powder (D50)]

The following electromagnetic wave suppressing sheets were manufactured.

A flat magnetic powder which has an average particle size (D50) of 50 µm or 24 µm was used. An aspect ratio of the magnetic powder having the average particle size (D50) of 50 µm was 92, and an aspect ratio of the magnetic powder having the average particle size (D50) of 24 µm was 83.

The content of the magnetic powder was 35 vol%. As the magnetic powder, an amorphous magnetic alloy composed of Fe_{67.9}Co₄Ni₄Sn_{3.5}P_{8.8}C_{10.8}B₁ (at%) was used.

Chlorinated polyethylene ('ELASLEN', manufactured by Showa Denko Kabushiki Kaisha) having a chlorination degree of 30 mass% was used.

In a test, a real part ε' of a complex relative permittivity and an imaginary part ε" of the complex relative permittivity in an in-plane direction of each electromagnetic wave suppressing sheet were obtained at a frequency of 1 GHz or 700 MHz. The test result is shown in the following Table 6.

**[Table 6]**

| | ε' at 1 GHz | E" at 1 GHz | ε' at 700 MHz | **ε**" at 700 MHz |
|---|---|---|---|---|
| D50=50 µm | 195.2 | 38.1 | 203.0 | 42.3 |
| D50=24 µm | 130.9 | 8.0 | 132.4 | 8.2 |

As shown in Table 6, it was known that the real part ε' of the complex relative permittivity and the imaginary part ε" of the complex relative permittivity are greatly increased when the average particle size (D50) of the magnetic powder is large.

In addition, based on the test result, it was confirmed that it is more preferable that the average particle size (D50) of the magnetic powder is in the range of 24 µm to 50 µm.

### [Test Example 5: Internal Structures of Example and Comparative Example (Fe-Si-Ai)]

The following electromagnetic wave suppressing sheets were manufactured.

In an example, an amorphous magnetic powder (content 35 vol%) composed of Fe_{67.9}Co₄Ni₄Sn_{3.5}Pa_{8.8}C_{10.8}B₁ was used. An average particle size (D50) of the magnetic powder of the example was 56 µm, and an aspect ratio thereof was 100.

Meanwhile, in a comparative example, a magnetic powder of a Fe-Si-Al alloy (content 35 vol%), used in Test Example 1, was used. An average particle size (D50) of the magnetic powder of the comparative example was 50 µm, and an aspect ratio thereof was 100.

In the example and comparative example, chlorinated polyethylene (ELASLEN, manufactured by Showa Denko Kabushiki Kaisha) having a chlorination degree of 30 mass% was used.

Fig. 9A is a scanning electron micrograph (SEM photograph) of a cross section cut in a film thickness direction of the electromagnetic wave suppressing sheet of the example, and Fig. 9B is a scanning electron micrograph (SEM photograph) of a cross section cut in a film thickness direction of the electromagnetic wave suppressing sheet of the comparative example.

A part viewed like a line in a substantially horizontal direction is a cross section of the flat magnetic powder. It is known that the magnetic powder is dispersed in a layer shape.

It was known that an amount of internally-formed bubbles of the example of Fig. 9A was smaller than that of the comparative example of Fig. 9B and the chlorinated polyethylene densely fills a space between the layers of magnetic powder.

A sheet thickness of the electromagnetic wave suppressing sheet of the example of Fig. 9A was 86 µm, and a sheet thickness of the electromagnetic wave suppressing sheet of the comparative example of Fig. 9B was 205 µm.

### [Test Example 6: Relationship between Frequency Band of 500 MHZ to 9 GHz and Real Part ε' of Complex Relative Permittivity and Imaginary Part ε" of Complex Relative Permittivity in In-plane Direction of Sheet]

The following 4 electromagnetic wave suppressing sheets were manufactured.

For a first electromagnetic wave suppressing sheet, a magnetic powder which has a composition of Fe_{67.9}Co₄Ni₄Sn_{3.5}P_{8.8}C_{10.8}B₁ (at%), an average particle size (D50) of 80 µm, and an aspect ratio of 96, and chlorinated polyethylene (ELASLEN, manufactured by Showa Denko Kabushiki Kaisha) which has a chlorination degree of 40% were used. A sheet thickness was 91 µm.

For a second electromagnetic wave suppressing sheet, a magnetic powder which has a composition of Fe_{67.9}Co₄Ni₄Sn_{3.5}P_{8.8}C_{10.8}B₁ (at%), an average particle size (D50) of 80 µm, and an aspect ratio of 87, and chlorinated polyethylene (ELASLEN, manufactured by Showa Denko Kabushiki Kaisha) which has a chlorination degree of 35% were used. A sheet thickness was 86 µm.

For a third electromagnetic wave suppressing sheet, a magnetic powder which has a composition of Fe_{67.9}Co₄Ni₄Sn_{3.5}P_{8.8}C_{10.8}B₁ (at%), an average particle size (D50) of 80 µm, and an aspect ratio of 102, and chlorinated polyethylene (ELASLEN, manufactured by Showa Denko Kabushiki Kaisha) which has a chlorination degree of 40% were used. A sheet thickness was 65 µm.

For a fourth electromagnetic wave suppressing sheet, a magnetic powder which has a composition of Fe_{67.9}CO₄Ni₄Sn_{3.5}P_{8.8}C_{10.8}B₁ (at%), an average particle size (D50) of 80 µm, and an aspect ratio of 98, and chlorinated polyethylene (ELASLEN, manufactured by Showa Denko Kabushiki Kaisha) which has a chlorination degree of 35% were used. A sheet thickness was 59 µm.

Using each electromagnetic wave suppressing sheet, a real part ε' of a complex relative permittivity and an imaginary part of the complex relative permittivity in an in-plane direction of the sheet were measured in a frequency band of 500 MHz to 9 GHz.

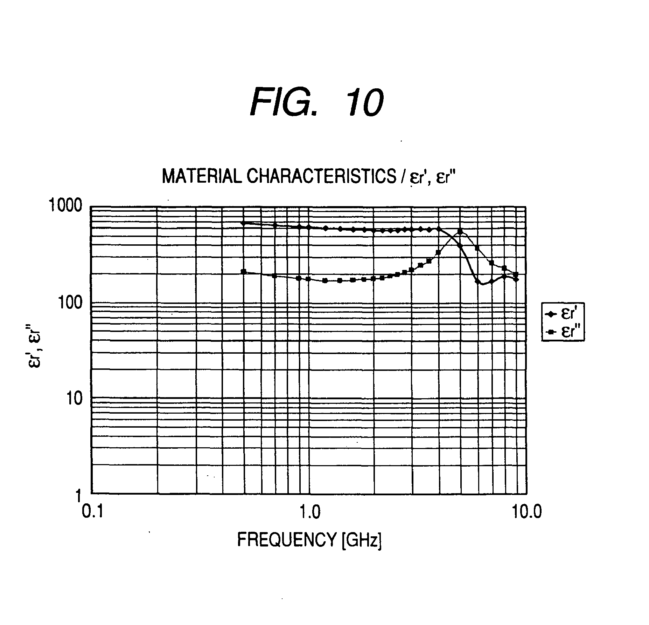

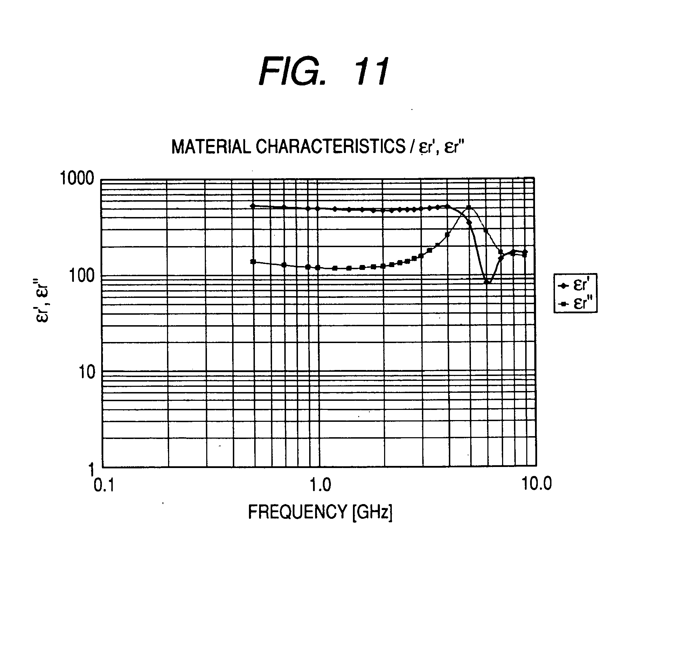

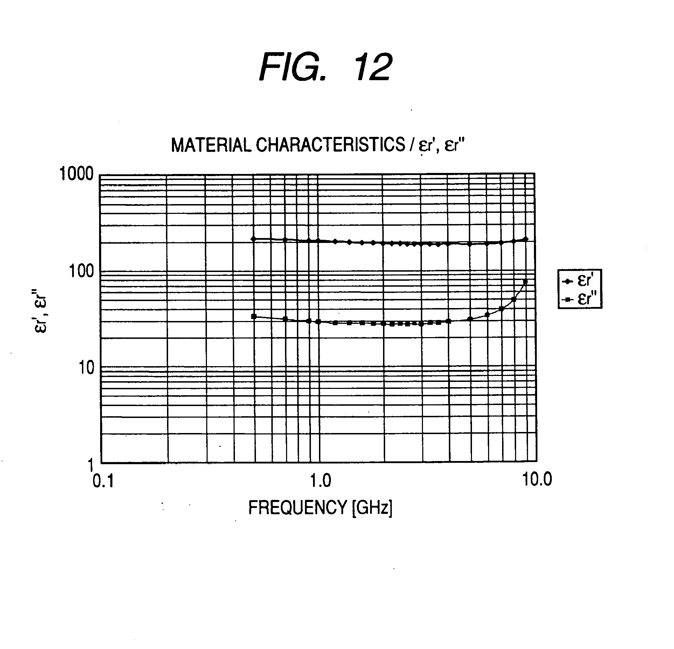

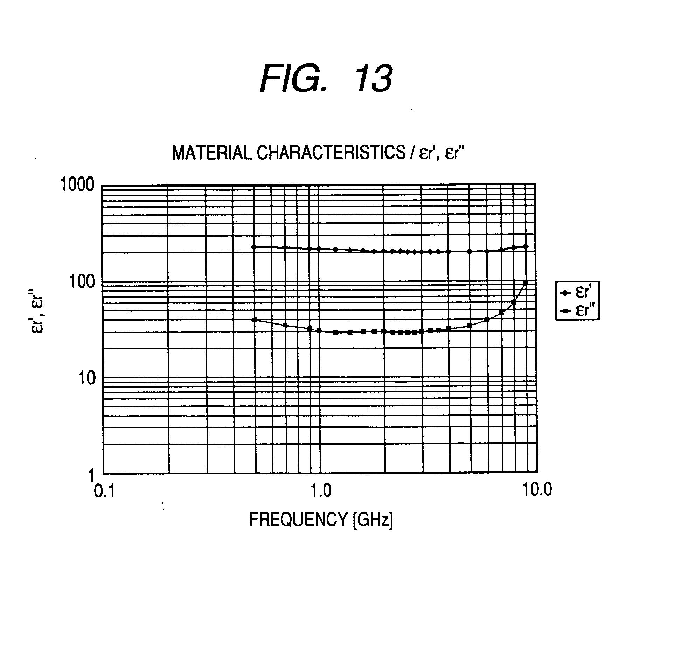

Fig. 10 shows a measurement result of the real part ε' of the complex relative permittivity and the imaginary par ε" of the complex relative permittivity, which were obtained using the first electromagnetic wave suppressing sheet, Fig. 11 shows a measurement result of the real part ε' of the complex relative permittivity and the imaginary par ε" of the complex relative permittivity, which were obtained using the second electromagnetic wave suppressing sheet, Fig. 12 shows a measurement result of the real part ε' of the complex relative permittivity and the imaginary par ε" of the complex relative permittivity, which were obtained using the third electromagnetic wave suppressing sheet, and Fig. 13 shows a measurement result of the real part s' of the complex relative permittivity and the imaginary par ε" of the complex relative permittivity, which were obtained using the fourth electromagnetic wave suppressing sheet.

In any of the test results, high real part ε' of the complex relative permittivity and imaginary par ε" of the complex relative permittivity in the in-plane direction of sheet were obtained in a frequency band of 500 MHz to 9 GHz.

Specifically, as shown in Figs. 10 to 13, the real part ε' of the complex relative permittivity of about 200 to 600 can be obtained, and the imaginary part ε" of the complex relative permittivity of about 25 to 500 can be obtained. Further, as shown in Fig. 8 explained previously, it was known that the real part ε' of the complex relative permittivity and the imaginary part ε" of the complex relative permittivity can be increased to about 900.

### [Test Example 7: Anisotropy of complex Relative Permittivities ε" and ε"]

The following electromagnetic wave suppressing sheet was manufactured.

An electromagnetic wave suppressing sheet using chlorinated polyethylene ('DAISORAC C130', manufactured by DAISO Co., Ltd.) having a chlorination degree of 30 mass% was formed, and a real part ε' of a complex relative permittivity and an imaginary part ε" of the complex relative permittivity in an in-plane direction and a thickness direction of the electromagnetic wave suppressing sheet were measured.

As a magnetic powder, an amorphous magnetic alloy composed of Fe_{67.9}Co₄Ni₄Sn_{3.5}P_{8.8}C_{10.8}B₁ (at%) was used. The magnetic powder was flat. In addition, an average particle size (D50) of the magnetic powder was 56 µm, and an aspect ratio thereof was 100. The content of the magnetic powder was 35 vol%.

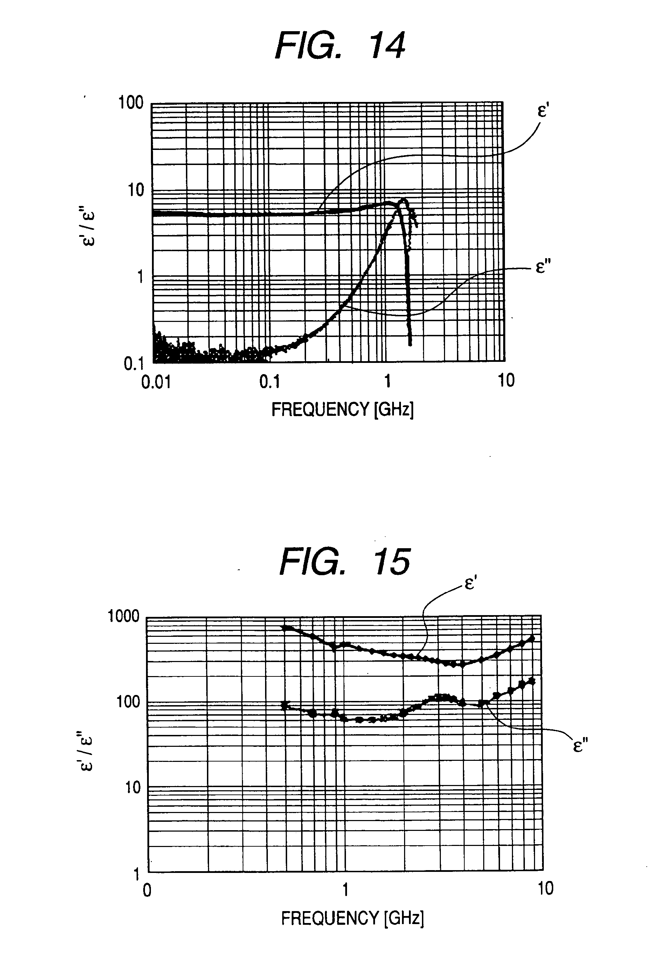

Fig. 14 shows a frequency characteristic of the real part ε' of the complex relative permittivity and the imaginary part ε" of the complex relative permittivity in the thickness direction of the electromagnetic wave suppressing sheet, and Fig. 15 shows a frequency characteristic of the real part ε' of the complex relative permittivity and the imaginary part ε" of the complex relative permittivity in the in-plane direction of the electromagnetic wave suppressing sheet.

From Figs. 14 and 15, it was known that the real part ε' of the complex relative permittivity in the in-plane direction of the electromagnetic wave suppressing sheet of this Example is about 100 times at 500 MHz, and about 70 times at 1 GHz and the imaginary part ε" of the complex relative permittivity in the in-plane direction of the electromagnetic wave suppressing sheet is about 150 times at 500 MHz, and about 20 times at 1 GHz, as compared with those in the thickness direction. An electromagnetic wave suppressing force can be greatly improved by an anisotropy of such a high complex relative permittivity.

## Claims

1. An electromagnetic wave suppressing sheet which includes a magnetic powder (2) and an insulating material (3),
wherein a real part (ε') of a permittivity (ε) in an in-plane direction of the sheet is 200 or more, and an imaginary part (ε") thereof is 25 or more.

2. An electromagnetic wave suppressing sheet which includes a magnetic powder (2) and a insulating material (3),
wherein a real part (ε') and an imaginary part (ε") of a permittivity (ε) have an anisotropy in an in-plane direction of the sheet.

3. The electromagnetic wave suppressing sheet according to Claim 1 or 2,
wherein the filling density of the magnetic powder (2) is in the range of 2.3 g/cm³ to 3.5 g/cm³.

4. The electromagnetic wave suppressing sheet according to any of Claims 1 to 3,
wherein the content of the magnetic powder (2) is in the range of 30 vol% or more and less than 45 vol%.

5. The electromagnetic wave suppressing sheet according to Claim 4,
wherein the content of the magnetic powder (2) is in the range of 30 vol% to 40 vol%.

6. The electromagnetic wave suppressing sheet according to any of Claims 1 to 5,
wherein an average particle size (D50) of the magnetic powder (2) is in the range of 24 µm to 70 µm.

7. The electromagnetic wave suppressing sheet according to any of Claims 1 to 6,
wherein an aspect ratio of the magnetic powder (2) is in the range of 10 to 800.

8. The electromagnetic wave suppressing sheet according to any of Claims 1 to 7,
wherein the magnetic powder (2) is a Fe-based amorphous alloy containing a low annealing promotion element M of 5 at% or less and Ni of 10 at% or less, where M is at least one selected from a group consisting of Sn, In, Zn, Ga, Co, and A1, and a flat magnetic metal alloy represented by a composition formula Fe_{100-a-b-x-y-z-w-t}MₐNi_{b}CrₓP_{y}C_{z}B_{w}Siₜ (where 0 at%≤a≤5 at%, 0 at%≤b≤10 at%, 0 at%≤x≤ 4 at%, 6 at%≤y≤13 at%, 2 at%≤z≤12 at%, 0 at%≤w≤5 at%, and 0 at%≤t≤ 4 at%), the magnetic powder (2) is dispersed in layers in a film thickness direction with the insulating material (3) disposed therebetween, the insulating material (3) is formed of chlorinated polyethylene having a chlorination degree of 30 mass% to 40 mass%, and a sheet thickness is in the range of 20 µm to 200 µm.
